## Europäisches Patentamt

## European Patent Office

## Office européen des brevets

(11) Veröffentlichungsnummer: **0 363 830**
**A1**

# EUROPÄISCHE PATENTANMELDUNG

(21) Anmeldenummer: **89118543.1**

(22) Anmeldetag: **06.10.89**

(51) Int. Cl.⁵: **G01R 29/26**

(30) Priorität: **14.10.88 CH 3854/88**

(43) Veröffentlichungstag der Anmeldung:
**18.04.90 Patentblatt 90/16**

(84) Benannte Vertragsstaaten:
**CH DE FR GB IT LI SE**

(71) Anmelder: **ASEA BROWN BOVERI AG**
**Haselstrasse**
**CH-5401 Baden(CH)**

(72) Erfinder: **Königstein, Dietrich, Dr.**
**Oberriedenstrasse 61**
**CH-5412 Gebenstorf(CH)**
Erfinder: **Köster, Dieter**
**Allmendstrasse 30**
**CH-5300 Turgi(CH)**

(54) **Elektrische Anlage mit einer signalübertragenden galvanischen Verbindung und Störstromindikator für diese Anlage.**

(57) Die elektrische Anlage enthält zwei stromgespeiste Komponenten (a, b). Diese Komponenten sind jeweils über einen Leiter ($E_a$, $E_b$) an einen gemeinsamen Erdungspunkt ($M_p$) gelegt. Eine signalübertragende Verbindung (S) verknüpft die beiden Komponenten galvanisch miteinander.

Bei dieser Anlage sollen auch unter verschiedenen Betriebsbedingungen unerkannte Fehler bei der Signalübertragung in der galvanisch an die Komponenten (a, b) angeschlossenen Verbindung (S) mit Sicherheit vermieden werden.

Dies wird durch einen permanent in die Anlage eingebauten Störstromindikator erreicht, welcher in der signalübertragenden Verbindung (S) fliessende Störströme ($I_s$) detektiert und oberhalb eines die Signalübertragung gefährdenden Warnpegels anzeigt.

FIG.1

EP 0 363 830 A1

# ELEKTRISCHE ANLAGE MIT EINER SIGNALÜBERTRAGENDEN GALVANISCHEN VERBINDUNG UND STÖRSTROMINDIKATOR FÜR DIESE ANLAGE

## TECHNISCHES GEBIET

Die Erfindung betrifft eine elektrische Anlage gemäss dem Oberbegriff von Patentanspruch 1 und einen Störstromindikator für diese Anlage.

## STAND DER TECHNIK

Hierbei nimmt die Erfindung auf einen Stand der Technik von elektrischen Anlagen Bezug, wie er etwa in der DE-A1-35 13 091 beschrieben ist. Die bekannte Anlage weist eine geerdete Prüfzelle auf, in der ein stromgespeistes Gerät mit elektromagnetischen Pulsen geprüft wird. In der Nähe dieses Gerätes ist ein zur Messung elektrischer und/oder optischer Signale vorgesehener Sensor angeordnet, dessen Messignale über eine Verbindung nach aussen an ein geerdetes Messgerät geführt werden. Bei Verwendung eines abgeschirmten Messkabels als signalübertragende Verbindung zwischen Prüfzelle und dem Messgerät verbindet die Schirmung des Messkabels die geerdeten Gehäuse von Prüfzelle und Messgerät galvanisch. Weist nun die Impedanz des Messkabels verglichen mit den Impedanzen von Masse-/Erdungsleitern, welche Prüfzelle und/oder Messgerät mit einem Masse-/Erdungspunkt verbinden, einen geringen Wert auf, so kann das Messkabel gegebenenfalls einen Störstrom führen, dessen Grösse ausreicht, um die Uebertragung der Messignale erheblich zu beeinträchtigen.

Des weiteren nimmt die Erfindung auf einen Stand der Technik von Störstromindikatoren Bezug, wie er etwa als Koppelzange bei der Fehlersuche in elektrischen Anlagen Verwendung findet.

## DARSTELLUNG DER ERFINDUNG

Die Erfindung, wie sie in den Patentansprüchen 1 und 3 angegeben ist, löst die Aufgabe, bei einer elektrischen Anlage der eingangs genannten Art auch unter verschiedenen Betriebsbedingungen unerkannte Fehler bei der Signalübertragung in der galvanisch an die Komponenten angeschlossenen Verbindung mit Sicherheit zu vermeiden, und zugleich einen für diese Anlage geeigneten Störstromindikator anzugeben.

Die erfindungsgemässe elektrische Anlage zeichnet sich dadurch aus, dass durch permanente Ueberwachung kritischer Anlageverbindungen unerwünscht grosse Störströme sofort angezeigt werden. Durch geeignete Gegenmassnahmen, wie Aenderung der Erdungsverhältnisse oder Aenderung der als gestört erkannten signalübertragenden galvanischen Verbindung, kann die elektrische Anlage nun rechtzeitig fehlerfrei gemacht werden. Zeitraubende Fehlersuche entfällt daher. In dem Augenblick, in dem etwa durch Umstecken eine falsche Verbindung hergestellt wird, erfolgt sofort eine die Rücknahme dieser unerwünschten Handlung bewirkende Warnung. Der Störstromindikator nach der Erfindung lässt sich einfach und kostengünstig herstellen. Er benötigt im allgemeinen keine zusätzliche Energieversorgung und bedarf auch nach langjährigem Einsatz praktisch keiner Wartung.

## KURZE BESCHREIBUNG DER ZEICHNUNG

Nachfolgend wird die Erfindung anhand eines in der Zeichnung beschriebenen Ausführungsbeispiels näher erläutert. Hierbei zeigt:

Fig. 1 ein Prinzipschaltbild einer Ausführungsform einer elektrischen Anlage nach der Erfindung, und

Fig. 2 ein Prinzipschaltbild des in der elektrischen Anlage gemäss Fig. 1 vorgesehenen Störstromindikators nach der Erfindung.

## WEG ZUR AUSFÜHRUNG DER ERFINDUNG

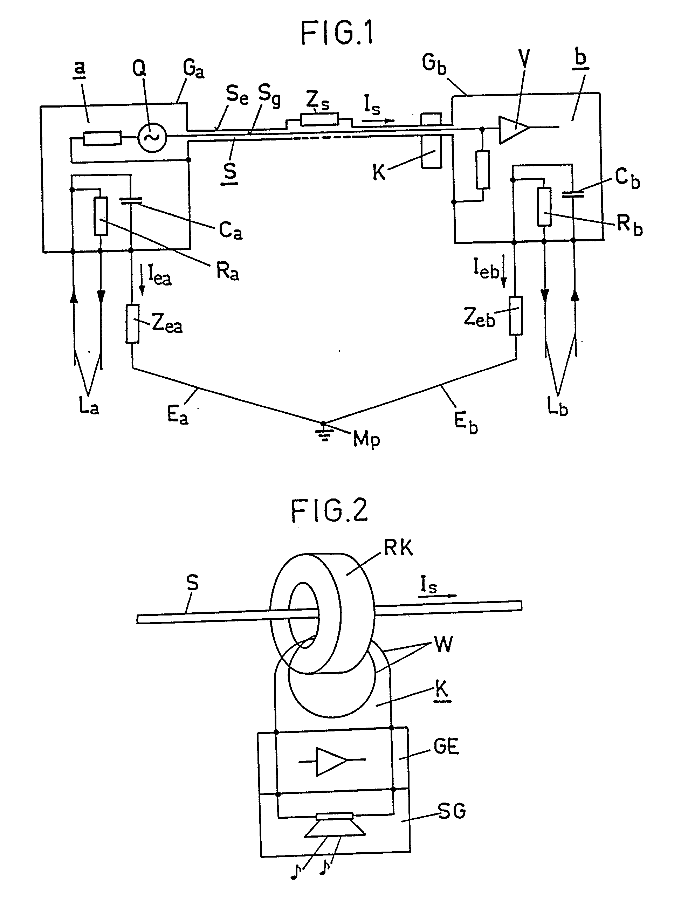

Die in Fig. 1 dargestellte elektrische Anlage enthält zwei elektrische Komponenten a und b. Die beispielsweise als Rechner einer Datenverarbeitungsanlage oder als Prüfzelle einer Messeinrichtung ausgebildete Komponente a enthält ein elektrisch leitendes Gehäuse $G_a$, welches über einen Masse-/Erdungsleiter $E_a$ an einen Masse-/Erdungspunkt $M_p$ geführt ist. Entsprechend weist die beispielsweise als Peripheriegerät einer Datenverarbeitungsanlage oder Messgerät ausgebildete Komponente b ein elektrisch leitendes Gehäuse $G_b$ auf, welches über einen Masse-/Erdungsleiter $E_b$ an den Masse-/Erdungspunkt $M_p$ geführt ist. Die Leiter $E_a$, $E_b$ weisen vom Betriebszustand der elektrischen Anlage abhängige Impedanzen $Z_{ea}$, $Z_{eb}$ auf.

In der Komponente a ist eine Signalquelle Q vorgesehen. Diese Signalquelle ist einerseits über einen nicht bezeichneten Widerstand an das Gehäuse $G_a$ gelegt und ist andererseits an den Innenleiter $S_g$ einer zur Komponente b geführten signalübertragenden Verbindung S, wie etwa einem koaxialen Messkabel oder einem Bussystem mit einer Schirmung $S_e$, angeschlossen. Der Innenleiter $S_g$ der signalübertragenden Verbindung S ist mit einem Eingang einer im Gehäuse $G_b$ angeordneten und etwa als Verstärker ausgebildeten Signalsenke V verbunden, während die Schirmung $S_e$ galvanisch mit den Gehäusen $G_a$ und $G_b$ verbunden ist. Die Impedanz der Verbindung S ist mit $Z_s$ bezeichnet.

K bezeichnet einen permanent an der signalübertragenden Verbindung S vorgesehenen Störstromindikator. Dieser Störstromindikator weist einen das Magnetfeld der Störströme erfassenden Sensor auf, welcher wie aus Fig. 2 ersichtlich ist als ferromagnetischer, bewickelter Ringkern RK ausgebildet sein kann. Der eine Wicklung W tragende Ringkern RK kann geschnitten oder geschlossen ausgebildet sein und kann je nach Ausbildung durch zangenförmiges Schliessen oder durch Aufschieben auf die Verbindung S in die elektrische Anlage eingebaut werden. Ferner weist der Störstromindikator einen vom Sensor mit Signalen beaufschlagbaren und die Grösse der erfassten Störströme anzeigenden, vorzugsweise akustische, optische oder elektrische Signale abgebenden Signalgeber SG auf. In einer besonders einfachen Ausführungsform der Erfindung kann dieser Signalgeber beispielsweise ein an die Wicklung W des Sensors angeschlossener Lautsprecher (Fig. 2), ein piezoelektrischer Wandler, eine optische Anzeige oder ein Relais sein. Wie aus Fig. 2 ersichtlich ist, kann die Wicklung W gegebenenfalls auch über eine Gleichrichter-, Verstärker- und Regeleinrichtung GE auf den Signalgeber SG wirken. Dies ist dann angezeigt, wenn der Störstromindikator K eine hohe Empfindlichkeit aufweisen soll, und wenn besonders kleine Warnpegel erfasst werden sollen.

$L_a$ und $L_b$ bezeichnen Anschlussleiter von Stromquellen. Diese Anschlussleiter sind jeweils über Durchführungen an einen in den Gehäusen $G_a$ und $G_b$ befindlichen Verbraucher $R_a$ und $R_b$, wie beispielsweise die Signalquelle Q und die Signalsenke V, geführt. Gegebenenfalls auf den Anschlussleitungen $L_a$ bzw. $L_b$ auftretende Störsignale werden durch Kondensatoren $C_a$ bzw. $C_b$ ausgefiltert. Diese Kondensatoren sind jeweils zwischen eine der Anschlussleitungen $L_a$ bzw. $L_b$ und das Gehäuse $G_a$ bzw. $G_b$ geschaltet.

Beim Betrieb einer solchen elektrischen Anlage können unerwünscht grosse Störströme $I_s$ in der Verbindungsleitung S auftreten. Dies ist immer dann der Fall, wenn die an die Gehäuse $G_a$ und $G_b$ gelegten Massenbezugspunkte der signalübertragenden Verbindung S unterschiedliches Potential haben, und wenn die Impedanz $Z_s$ der Verbindung S klein gegen die Impedanzen $Z_{ea}$ und/oder $Z_{eb}$ ist. Solche unterschiedlichen Potentiale treten etwa dann auf, wenn auf den Masse-/Erdungsleitern $E_a$, $E_b$ zum gemeinsamen Masse-/Erdungspunkt $M_p$ Ströme fliessen. Solche in Fig. 1 mit $I_{ea}$ bzw. $I_{eb}$ bezeichnete Ströme können etwa durch die auf den Anschlussleitern $L_a$ bzw. $L_b$ in die Systeme a bzw. b eingedrungenen Störsignale hervorgerufen werden. Diese Störsignale werden über die Kondensatoren $C_a$ bzw. $C_b$ ausgefiltert und fliessen nun als Strom $I_{ea}$ und $I_{eb}$ über die Masse-/Erdungsleitungen $E_a$ bzw. $E_b$ zum gemeinsamen Masse-/Erdungspunkt $M_p$ beider Komponenten.

Störströme $I_s$ können aber auch durch Einkoppelung von elektromagnetischen Störfeldern in die räumlich ausgedehnten und von der signalübertragenden Verbindung S sowie den beiden Masse-/Erdungsleiter $E_a$, $E_b$ gebildeten Schleife induziert werden. Diese Störströme $I_s$ beeinflussen je nach Koppelgrad zwischen dem von der Schirmung $S_e$ gebildeten Störstromkreis und dem vom Innenleiter $S_g$ gebildeten Signalkreis die Signalübertragung erheblich. Diese Beeinflussung ist bei elektrischen Anlagen besonders stark, bei denen die Signalleitung, wie etwa bei Temperaturmessungen mittels Thermoelementen, zugleich beide Systeme a und b galvanisch verbindet. Erschwerend kommt noch dazu, dass die in die signalübertragende Verbindung V eingekoppelten Störströme $I_s$ in Abhängigkeit vom Lastzustand der gesamten elektrischen Anlage schwanken und daher oft nur durch Zufall zu erkennen sind.

Durch permanente Anordnung des Störstromindikators können nun bei Betrieb der elektrischen Anlage gegebenenfalls auftretende und einen vorgegebenen Warnpegel überschreitende Störströme $I_s$ fortlaufend erfasst und signalisiert werden.

Bei dem in Fig. 2 angegebenen Störstromindikator induzieren versorgungsnetzabhängige Brummstörungen, welche als Störströme $I_s$ in der als Primärwicklung eines Transformators wirkenden Verbindung S fliessen, in der als Sekundärwicklung des Transformators wirkenden Wicklung W Messströme. Diese Messströme werden von dem als Lautsprecher ausgebildeten Signalgeber SG als amplitudenabhängiger Brummton angezeigt. Hierdurch lassen sich in kostengünstiger und praktisch wartungsfreier Weise und ohne Verwendung einer zusätzlichen Stromversorgung bzw. einer zwischen die Wicklung W und den Lautsprecher geschalteten Gleichrichter-Verstärker- und Regeleinrichtung oberhalb 100 mA gelegene Störströme anzeigen.

**Ansprüche**

1. Elektrische Anlage mit mindestens zwei stromgespeisten Komponenten (a, b), welche jeweils über mindestens einen Masse-/Erdleiter ($E_a$, $E_b$) an einem gemeinsamen Massen-/Erdungspunkt ($M_p$) geführt sind, und mit mindestens einer an die mindestens zwei elektrischen Komponenten (a, b) angeschlossenen, signalübertragenden galvanischen Verbindung (S), gekennzeichnet durch mindestens einen Störströme ($I_S$) in der mindestens einen signalübertragenden galvanischen Verbindung (S) permanent erfassenden Störstromindikator (K).

2. Anlage nach Anspruch 1, dadurch gekennzeichnet, dass bei mindestens einer der beiden Komponenten (a, b) der Strom über mindestens einen gegen die Masse der Komponente gelegten und Störsignale aus dem Strom filternden Kondensator ($C_a$, $C_b$) eingespeist wird.

3. Störstromindikator für die elektrische Anlage nach Anspruch 1, gekennzeichnet durch mindestens einen Störströme ($I_S$) in der mindestens einen signalübertragenden galvanischen Verbindung (S) permanent erfassenden Sensor und mindestens einen mit einem Ausgang des Sensors in Wirkverbindung stehenden und die Grösse der erfassten Störströme ($I_S$) anzeigenden Signalgeber (SG).

4. Störstromindikator nach Anspruch 3, dadurch gekennzeichnet, dass der mindestens eine Sensor einen geschnittenen oder auf die mindestens eine signalübertragende galvanische Verbindung (S) aufschiebbaren ferromagnetischen Kern (RK) mit mindestens einer Wicklung (W) aufweist.

5. Störstromindikator nach Anspruch 4, dadurch gekennzeichnet, dass die mindestens eine Wicklung (W) mit einem Eingang eines optischen, akustischen oder elektrischen Signalgebers (SG) verbunden ist.

6. Störstromindikator nach Anspruch 5, dadurch gekennzeichnet, dass der mindestens eine Signalgeber (SG) ein Lautsprecher ist.

7. Störstromindikator nach Anspruch 4, dadurch gekennzeichnet, dass die mindestens eine Wicklung (W) über eine Gleichrichter-, Verstärker- und Regel-Einrichtung (GE) auf den mindestens einen Signalgeber (SG) wirkt.

## FIG.1

## FIG.2

| | Europäisches Patentamt | EUROPÄISCHER RECHERCHENBERICHT | Nummer der Anmeldung |
| --- | --- | --- | --- |

EP 89 11 8543

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.5) |
| --- | --- | --- | --- |
| Y | M.J: WILSON: "The ARRL handbook for the radio amateur", 1988, Auflage 65, Seiten 8.35,8.36, The American Radio Relay League, Newington, US * Seiten 8.35 "Noise Precautions" * --- | 1-5 | G 01 R 29/26 |
| Y | WIRELESS WORLD, Band 80, Nr. 1463, Juli 1974, Seiten 255-259; A.S. McLACHLAN et al.: "Radio interference" * Figur 9 * --- | 1-5 | |
| A | AU-B- 70 835 (HAJIME INDUSTRIES LTD) * Seite 8, Zeilen 23-30 * --- | 5-7 | |
| A | US-A-2 499 410 (W.D. NUPP) * Spalte 2, Zeilen 26-48 * ----- | 5-7 | |

RECHERCHIERTE SACHGEBIETE (Int. Cl.5)

G 01 R

Der vorliegende Recherchenbericht wurde für alle Patentansprüche erstellt

| Recherchenort | Abschlußdatum der Recherche | Prüfer |
| --- | --- | --- |
| DEN HAAG | 14-11-1989 | LUT K. |

KATEGORIE DER GENANNTEN DOKUMENTE

X : von besonderer Bedeutung allein betrachtet
Y : von besonderer Bedeutung in Verbindung mit einer anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder nach dem Anmeldedatum veröffentlicht worden ist
D : in der Anmeldung angeführtes Dokument
L : aus andern Gründen angeführtes Dokument

& : Mitglied der gleichen Patentfamilie, übereinstimmendes Dokument

EPO FORM 1503 03.82 (P0403)